# EUROPEAN PATENT APPLICATION

(11) **EP 1 647 860 A1**
(43) Date of publication of application: **19.04.2006**
(21) Application number: 04745596.9
(22) Date of filing: 04.06.2004
(51) Int. Cl.: G03F 7/085, G03F 7/022

(54) **ADHESION IMPROVER FOR PHOTOSENSITIVE RESIN COMPOSITION AND PHOTOSENSITIVE RESIN COMPOSITION CONTAINING SAME**

(30) Priority: 09.06.2003 JP 2003163206
(71) Applicant: AZ Electronic Materials (Japan) K.K., Tokyo 113-0021 (JP); AZ Electronic Materials USA Corp., Somerville, NJ 08876 (US)
(72) Inventor: KOBAYASHI, Satoshi, c/o Clariant(Japan)K.K., Ogasa-gun, Shizuoka 437-1496 (JP); Shin, Dong-Myung, c/o Clariant AZ(Korea) Ltd., Ansung-city, Kyungki-do 456-840 (KR); TAKEDA, Takashi, c/o Clariant(Japan)K.K., Ogasa-gun, Shizuoka 437-1496 (JP)
(74) Representative: Isenbruck, Günter
(86) International application number: PCT/JP2004/007820
(87) International publication number: WO 2004/109404

(57) **Abstract**

An adhesion-improving agent comprising a sulfonyl group substituted nitrogen compound represented by the below described general formulae (1) to (5) or a thiadiazole compound represented by the below described general formulae (6) to (8) and a photosensitive resin composition containing an alkali-soluble resin and a photosensitizer,comprisingsaid adhesion-improving agent.

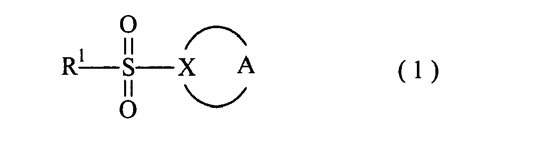

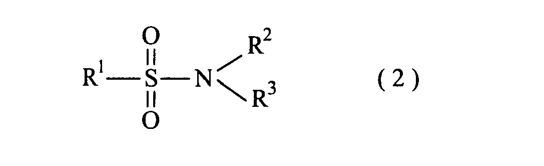

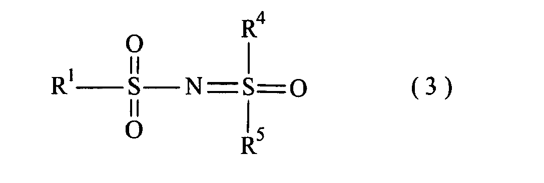

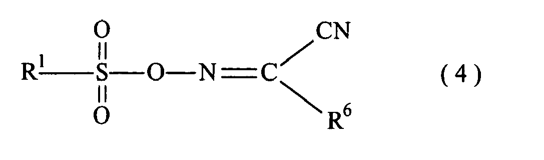

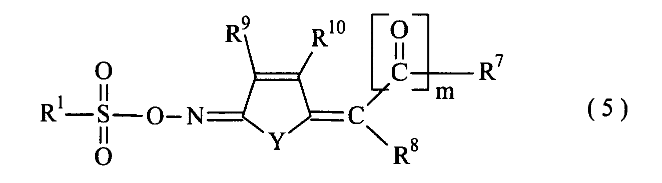

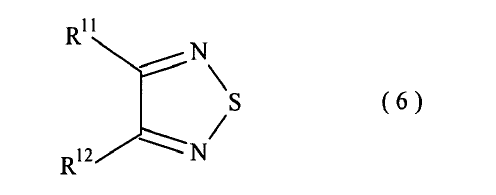

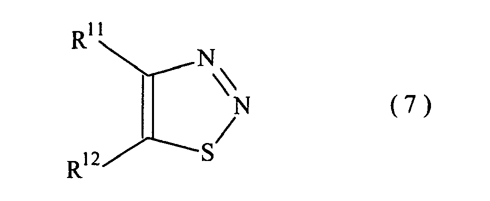

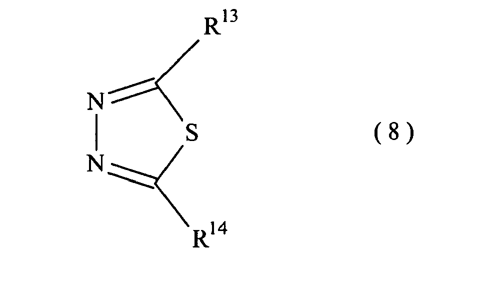

## Description

### Technical field

The present invention relates to an adhesion-improving agent for a photosensitive resin composition and the photosensitive resin composition containing the same. Further in detail, the present invention relates to the adhesion-improving agent applied for improving an adhesion property of a photosensitive resin composition onto a silicon substrate, a glass substrate and a substrate having a metal film thereon such as molybdenum (Mo), a metal oxide film, a non-metal oxide film and so on upon manufacturing a semiconductor integrated circuit device, a flat panel display (FPD) such as a liquid crystal display device and so on and to the photosensitive resin composition containing this adhesion-improving agent.

### Background art

In manufacturing of a semiconductor integrated circuit device such as IC, LSI and so on, a color filter and a flat panel display (FPD) such as a liquid crystal display device and so on, a lithography technology has been so far being applied in order to carry out a fine processing. In recent years, for these fine processing, a fine processing in sub-micron order or further quarter-micron order is required and a development of lithography technology to enable them is being carried out.

By the way, a resist pattern is formed on a substrate usually in the following ways in such lithography technology. It means that first an anti-reflective film is formed on a substrate, if necessary, after that a positive-working or a negative-working photosensitive resin composition is applied thereon, and the substrate is treated by heat (prebaking) to form a photoresist film. Thereafter this photoresist film is pattern-wise exposed to a various radiations such as ultra violet light, deep ultra violet light, electron beam, x ray and so on and then developed to form a resist pattern. As a method for applying the above described photosensitive resin composition, a various kind of methods such as a spin coating method, a roll coating method, a land coating method, a flowing and spreading method, a doctor coating method, a dip coating method, a slit coating method and so on are used.

The resist pattern obtained in this way is used as a mask in etching or an ion implantation and besides that, it is utilized as a filter formation material in manufacturing a color filter. In manufacturing a semiconductor integrated circuit device, a positive-working photosensitive resin composition is often being utilized as a resist material and a spin coating method is often applied as an application method. And also in manufacturing a flat panel display (FPD) such as a liquid crystal display device, a positive-workingphotosensitive resin composition is often being utilized as a resist material.

On the other hand, in the manufacturing process of a semiconductor device such as IC, LSI and so on, a thin film transistor (TFT), a liquid crystal display device and soon, a silicon substrate or a glass substrate has been so far being applied as a substrate. Further a metal film, a non-metal film, a metal oxide film, a non-metal oxide film and so on are laid on these substrates as necessary. These films to be laid on a substrate are concretely exemplified by an amorphous silicon film, a polysilicon film, a silicon nitride film, a silicon oxide film, an indium tin oxide film (ITO), a tin oxide film, an Al film, a Ta film, a Mo film, a Cr film and so on. These films are laid on a substrate by methods such as a CVD method, a spattering method, a vacuum deposition method, a heat-oxidation method and so on. The photosensitive resin composition is applied on these substrate materials, which include a substrate raw material and a substrate film material, and then a resist pattern is formed on the substrate. The obtained resist pattern is used as an etching protection film (a mask), for example and the substrate having resist patterns is dry-etched or wet-etched to form fine uneven patters.

In the photo-etching method such as the above description, it is known that an adhesion property between the photosensitive resin composition to be applied or the resist pattern to be formed and a substrate is significant in order to etch accurately a metal film and so on formed on a substrate. Because unless an adhesion property between the photosensitive resin composition and a substrate is good, a collapse or a peeling-off of a formed resist pattern is caused when a photoresist film, which is formed by applying the photosensitive resin composition, is pattern-wise exposed to light and is developed. Unless an adhesion property between a resist pattern and a substrate is good, a pattern collapse or a pattern peeling-off is also caused upon etching. If such pattern collapse or pattern peeling-off are caused, there occurs a problem that an yield in a mass production process inclines to decrease in a way such as a cutting-off or a shortage of wiring is taken place on wiring which is formed by etching. These pattern defects areparticularlytakenplace in the case where a filmwhereon the photosensitive resin composition is applied is a Mo film or a Ta film.

In order to improve an adhesion property between a photosensitive resin composition and a substrate, it is so far known that an adhesion-improving agent is added into a photosensitive resin composition. As examples of improvement of an adhesion property between a photosensitive resin composition and a substrate by applying the adhesion-improving agent like these cases, it is so far known that an adhesion property between a positive-working photosensitive resin composition and a substrate can be improved, for example by formulating benzimidazoles or polybenzimidazole into the positive-working photosensitive resin composition (Japanese Patent Publication Laid-Open No. Hei6-27657) and that an adhesion property between a positive- or negative-working photoresist composition and a substrate can be improved by incorporating benzotriazoles into the positive or negative-working photoresist composition (Japanese Patent Publication Laid-Open No. 2000-171968, Japanese Patent Publication Laid-Open No. Hei8-339087). However in any cases it is the current situation that a further improvement is being required against the situation that a storage stability of a photoresist composition (photosensitive resin composition) is damaged or an adhesion property in a severe condition is not enough.

An object of the present invention is to offer an adhesion-improving agent for a photosensitive resin composition having no such problems as described above so far taken place and the photosensitive resin composition containing the same.

It means that the object of the present invention is to offer an adhesion-improving agent for a photosensitive resin composition by which a storage stability of a photosensitive resin composition does not decrease and an extremely excellent adhesion property onto a substrate is provided for the photosensitive resin composition when incorporated into the photosensitive resin composition.

Other object of the present invention is to offer the photosensitive resin composition containing the adhesion-improving agent for the photosensitive resin composition described above which is excellent in an adhesion property with a substrate.

Furthermore other obj ect of the present invention is to offer the adhesion-improving agent for the photosensitive resin composition, which can provide a good adhesion property with a metal, a non-metal, a metal film, a non-metal film and so on upon development or etching, enables to process by etching with good accuracy and can contribute to increase an yield in a mass production process and to offer the photosensitive resin composition containing the same.

### Disclosure of the invention

As a result of eager studies and examinations, the present inventors found that the above-described objects can be attained by incorporating a particular sulfonyl group substituted nitrogen compound or thiadiazole compound in the photosensitive resin composition to enable to improve an adhesion property between a photoresist and a metal substrate and so on.

It means that the present invention relates to the adhesion-improving agent for the photosensitive resin composition comprising a sulfonyl group substituted nitrogen compound represented by the general formulae (1) to (5) or a thiadiazole compound represented by the general formulae (6) to (8). 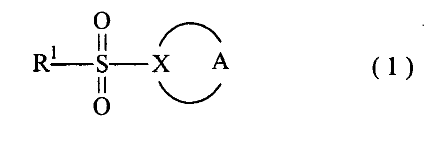 Wherein R¹ represents a hydrogen atom, a hydroxyl group, an alkyl group of C₁ to C₅, a phenyl group which may contain substituted groups, -R²¹OH, -R²²OR²³, a halogen atom, an amino group, a cyano group, -R²⁴NH₂, -R²⁵CN or an indole group which may contain substituted groups, R²¹, R²², R²⁴ and R²⁵ each independently represent an alkylene group or a phenylene group which may contain substituted groups, R²³ represents an alkyl group or a phenyl group which may contain substituted groups, X represents a carbon atom or a nitrogen atom, A represents a group of carbon atoms and/or nitrogen atoms which is required to form with X an aromatic hetero cyclic compound which may contain substituted groups. 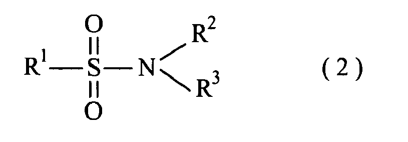 Wherein R¹ represents the group or the atom defined by the above description, R² represents an alkyl group or a phenyl group which may contain substituted groups and R³ represents a nitroso group or an amino group. 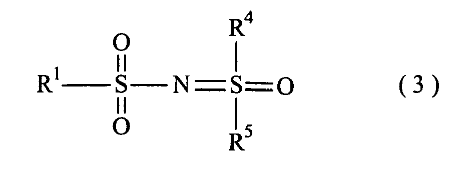 Wherein R¹ represents the group or the atom defined by the above description; R⁴ and R⁵ each independently represent an alkyl group or a phenyl group which may contain substituted groups. 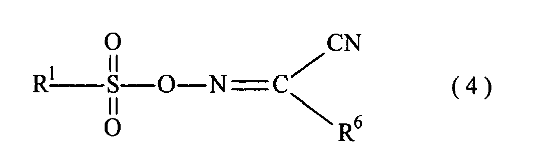 Wherein R¹ represents the group or the atom defined by the above description, R⁶ represents a naphthyl group or a phenyl group or a thiophene group which may contain substituted groups. 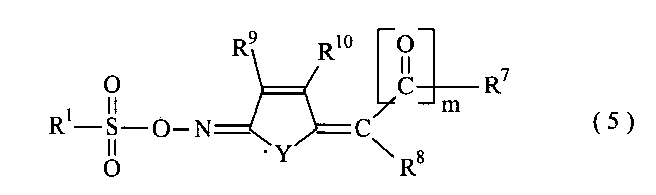 Wherein R¹ represents the group or the atom defined by the above description, R⁷ and R⁸ each independently represent a phenyl group, a heteroaryl group, an alkoxycarbonyl group, a phenoxycarbonyl group or a cyano group which may contain substituted groups, R⁹ and R¹⁰ each independently represent a hydrogen atom, a halogen atom, an alkyl group of C₁ to C₆, an alkoxy group of C₁ to C₆, a haloalkyl group of C₁ to C₄, a cyano group, a nitro group, an amino group, a substituted amino group, an alkoxycarbonyl group, a phenoxycarbonyl group, a phenyl group or an alkylthio group, R⁹ and R¹⁰ may form a condensed ring by bonding, Y represents an atom or atom group which is required to form a heterocyclic five members or six members ring such as, for example, a nitrogen atom, an oxygen atom a sulfur atom or a phosphorus atom or carbon atoms which is required to form carbon six members ring, and m represents 0 or 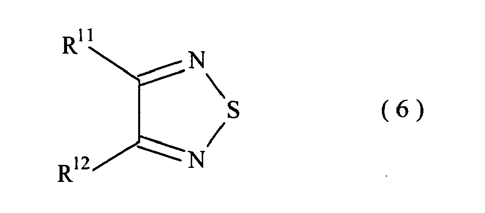 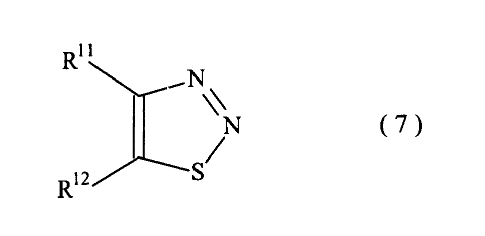 Wherein R¹¹ and R¹² each independently represent a hydrogen atom, a halogen atom, a sulfide group, an amino group, a sulfoneamide group, an alkyl group, a perfluoroalkyl group, a phenyl group which may contain substituted groups or a group forming a condensed ring by bonding R¹¹ and R¹², which is substituted by a nitro group or an amino group. 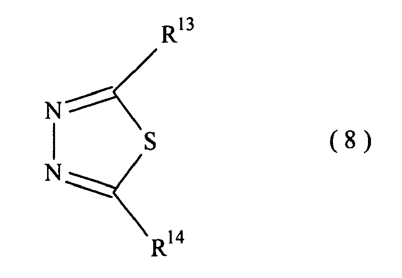 Wherein R¹³ and R¹⁴ each independently represent an alkyl group of C₁ to C₅, a thiol group, an alkylmercapto group, a sulfonyl group, an amide group, an amino group, a sulfoneamide group, an acetylamino group or a fluorinated alkyl group.

And the present invention also relates to the photosensitive resin composition which is characterized in comprising at least one species of a sulfonyl group substituted nitrogen compound represented by the general formulae (1) to (5) or a thiadiazole compound represented by the general formulae (6) to (8).

The present invention will be explained further in detail below.

The adhesion-improving agent for the photosensitive resin composition of the present invention is not particularly limited if it maybe anyone of a sulfonyl group substitutednitrogencompound or a thiadiazole compound represented by the general formulae (1) to (8). The sulfonyl group substituted nitrogen compound represented by the general formula (1) can be preferably exemplified by the compound represented by the general formula (9) or (10). 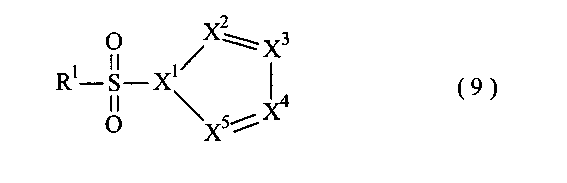 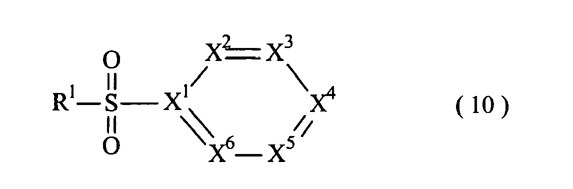 In the formulae (9) and (10), R¹ represents one as defined by the previous description, X¹ to X⁶ represent each independently a carbon atom or a nitrogen atom, in the case where the atoms neighboring each other are carbon atoms in X² to X⁶, substituting groups of these neighboring carbon atoms may be bonded each other to form a condensed ring.

More preferable examples of the sulfonyl group substituted nitrogen compound represented by the general formula (1) include compounds represented by the general formula (11), (12) or (13) described below. 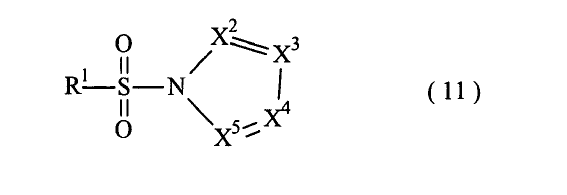 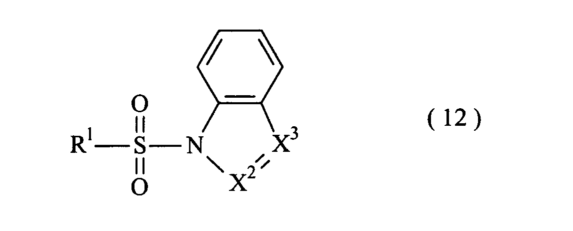 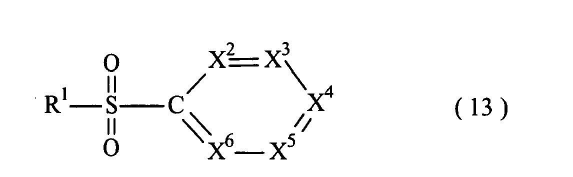 In the formulae (11) to (13), R¹ and X² to X⁶ represent one as defined by the previous description

The compounds represented by the general formula (1) can be concretely exemplified by 1-mesitylenesulfonyl-1, 2, 4 -triazole (the compound of below-described formula (1-1)), N-methanesulfonylimidazole (the compound of below-described formula (1-2)), 1-(phenylsulfonyl)pyrrole, (the compound of below-described formula (1-3)), N-(2,4,6-triisopropylbenzenesulfonyl)imidazole (the compound of below-described formula (1-4)), 1-(phenylsulfonyl)indole (the compound of below-described formula (1-5)), 1-(2,4,6- triisopropylbenzenesulfonyl)-1,2,4-triazole (the compound of below-described formula (1-6)), 4-chloro-3-Pyridinesulfoneamide hydrochloride (the compound of below-described formula (1-7)), 2-piridinesulfonylacetonitril (the compound of below-described formula (1-8)), for example. These compounds are on sale by Lancaster Synthesis Co., Ltd. and easily available from the market.

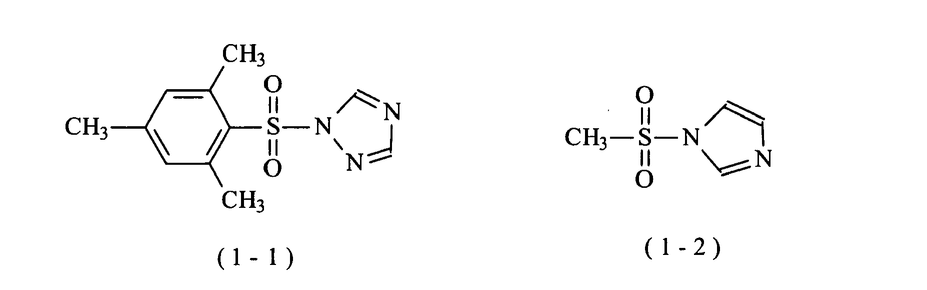

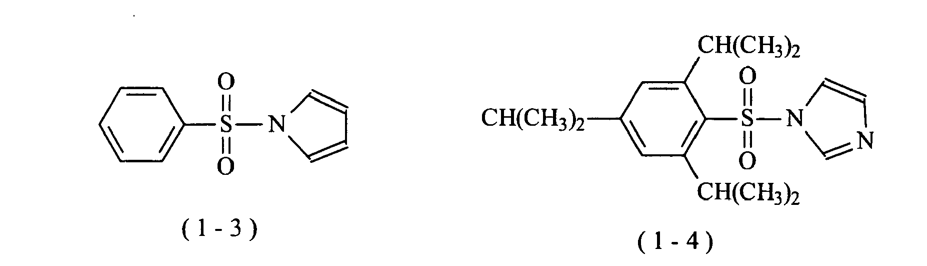

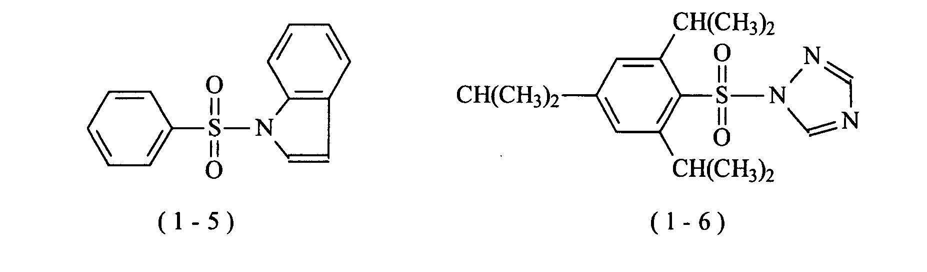

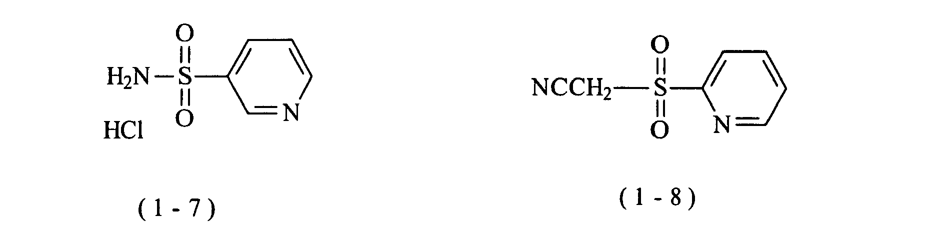

And the compounds represented by the above-described general formula (2) or (3) can concretely be exemplified by N-methyl-N-nitroso-p-toluene sulfoneamide (the compound of below-described formula (2-1)), S,S-dimethyl-N-(p-toluenesulfonyl)sulfoxyimine (the compound of below-described formula (3-1)), for example. These compounds are on sale by Lancaster Synthesis Co., Ltd. and easily available from the market.

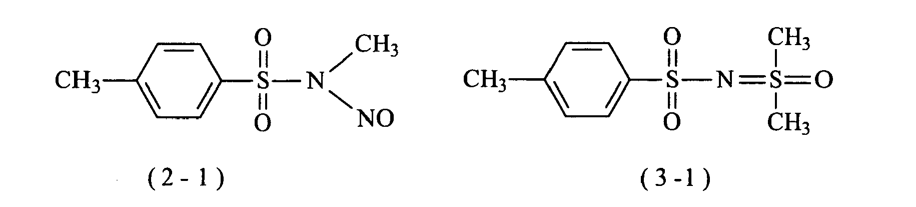

In the sulfonyl group substituted nitrogen compound represented by the general formula (4), a phenyl group and a thiophene group of R⁶, whichmaybe substituted is further concretely explained. A phenyl group which may be substituted can be preferably exemplified by a group represented by the below-described general formula (14). 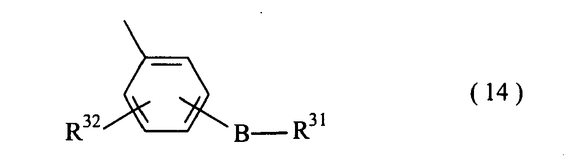 Wherein R³¹ represents a hydrogen atom, an unsubstituted alkyl group, an alkyl group which is substituted by a phenyl group, a hydroxyl group or an alkoxy group of C₁ to C₄ or may be interrupted by -O-, an unsubstituted phenyl group or a phenyl group which is substituted by a halogen atom, an alkyl group of C₁ to C₄ or an alkoxy group of C₁ to C₄, R³² represents a hydrogen atom or an alkyl group of C₁ to C₄ and B represents a direct bond or an oxygen atom.

The thiophenene group which maybe substituted canpreferably exemplified by a group represented by the below-described general formula (15). 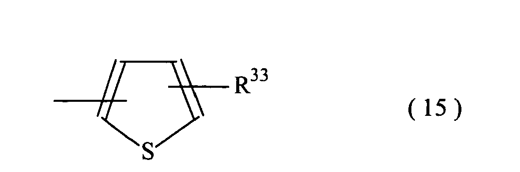 Wherein R³³ represents -B-R³¹ or R³², in which B, R³¹ and R³² represent one as defined by the previous description.

A compound represented by the above general formula (4) can be exemplified by α -(toluenesulfonyloxyimino)-4-methoxy benzylcyanide represented by the below-described formula (4-1), as an example.

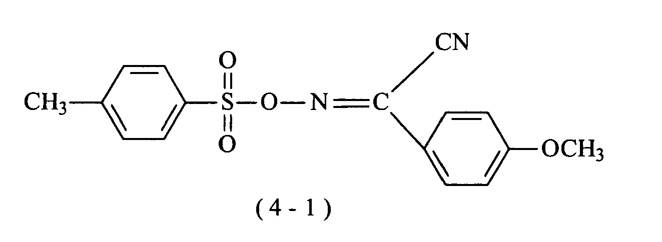

Further a compound represented by the general formula (5) can be exemplified by α-(methylsulfonyloxyimino)-thiophene-2 -methyl benzylcyanide represented by the below-described formula (5-1), for example.

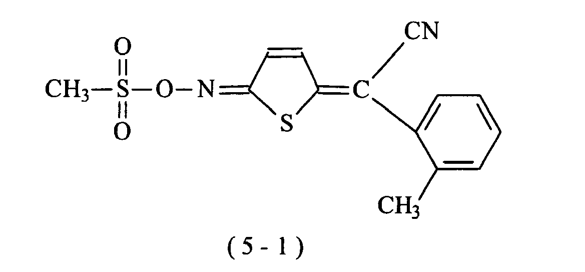

A compound represented by the above general formula (6) or (7) can be concretely exemplified by 4-aminobenzo-2, 1, 3-thiaziazole (a compound represented by the below-described formula (6-1)), 4-nitrobenzo-2,1,3-thiaziazole (a compound represented by the below-described formula (6-2)), 3,4-dichloro-1, 2, 5-thiaziazole (a compound represented by the below-described formula (6-3)), 4,5-diphenyl-1,2,3- thiaziazole (a compound represented by the below-described formula (7-1)), 4-(4-nitrophenyl)-1,2,3-thiadiazole) (a compound represented by the below-described formula (7-2)) as preferable ones. These compounds are on sale by Lancaster Synthesis Co., Ltd. and easily available from the market.

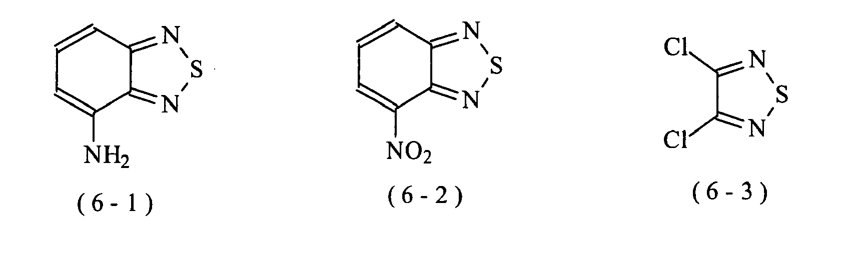

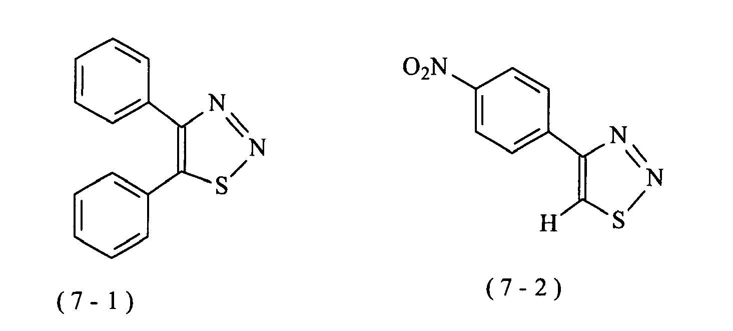

A compound represented by the general formula (8) can be concretely exemplified by 2,5-dimercapto-1,3,4-thiadiazole (a compound represented by the below-described formula (8-1)), 5-acetoamide-1,3,4-thiadiazole-2-sulfoneamide (a compound represented by the below-described formula (8-2)), 2-amino-5-tert-butyl-1,3,4-thiadiazole (a compound represented by the below-described formula (8-3)), 2-amino-5-ethylthio-1,3,4-thiadiazole (a compound represented by the below-described formula (8-4)), 2-amino-5-ethyl-1,3,4-thiadiazole (a compound represented by the below-described formula (8-5)), 2-amino-5-trifluoromethyl-1,3,4-thiadiazole (a compound represented by the below-described formula (8-6)), for example.

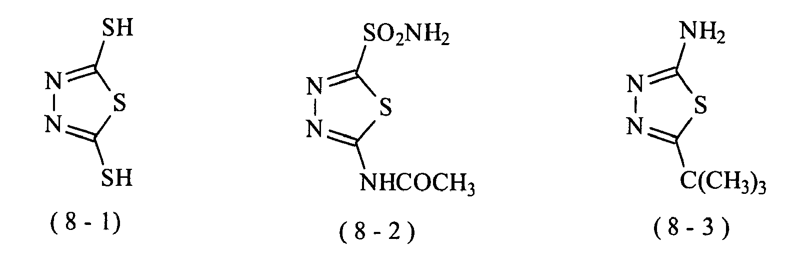

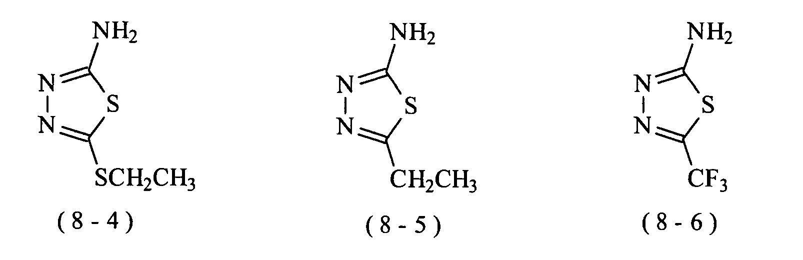

The adding amount of the adhesion-improving agent for the photosensitive resin composition of the present invention to the photosensitive resin composition is usually 10 to 50,000 ppm relative to a resin solid content of the photosensitive resin composition, preferably 100 to 5, 000 ppm. When the adding amount of the adhesion-improving agent for the photosensitive resin composition is less than 10 ppm, adhesion-improving effect of the photosensitive resin composition onto a substrate is not exhibited. On the other hand when the adding amount is higher than 50,000 ppm, problems such as a pattern-formation defect which is presumed to be caused by a bad development, a deterioration of sensitivity, a generation of a sublimated substance and so on are taken place.

In the present invention, although a mechanism of an adhesion property improvement of the photosensitive resin composition onto a substrate by incorporating a sulfonyl group-substituted nitrogen compound or a thiadiazole compound represented by the general formulae (1) to (8) is not yet solved clearly, it is roughly assumed to be brought by the followings. However, it is still just an assumption and the present invention is not limited by this at all. It means that a sulfonyl group-substituted nitrogen compound strengthens azo-coupling reaction (a purpose thereof is a preventing effect of a film thickness decrease caused by alkali-solubility controlling effect of unexposed area), which is well known in the photosensitive resin composition comprising novolak resin and diazo naphthoquinone sensitizer, by hydrogen bonding of sulfonyl group with a hydroxyl group of novolak resin to prevent alkali erosion upon development and then it is assumed to prevent decreasing in adhesion property thereby. In addition, an adhesion property with a substrate side can be increased by a cyclic nitrogen compound. It means that the cyclic nitrogen compound contains nitrogen which has affinity for a metal film and an oxide film. It seems that an electron lone pair in the nitrogen is high in its activity amongst similar nitrogen hetero-cyclic compounds such as imidazole and imidazoline by its aromatic structure or by a bonded phenyl group. Furthermore, affinity for a base polymer is high by a phenyl group substitution compared with similar benzotriazole compounds and therefore a sulfonyl group substituted nitrogen compound represented by the general formulae (1) to (5) have affinity for both an oxide film side and a base polymer side. Because of those reasons, it is assumed that an adhesion property between a photosensitive resin composition and a metal film or an oxide film is improved by incorporating the above described sulfonyl group substituted nitrogen compound into the photosensitive resin composition. On the other hand, as for thidiazoles since a thidiazole ring contains two nitrogen atoms which has an effectiveness to an adhesion property onto a substrate, or by electronic bonding between nitrogen atom or sulphur atom and atoms constituting a substrate forming material, it is estimated that the adhesion property with a substrate is improved.

An alkali-soluble resin in the photosensitive resin composition of the present invention can be exemplified by a novolak resin, a vinyl polymer having a phenolic hydroxyl group, a vinyl polymer having a carboxyl group and so on and the novolak resin is preferable. The alkali-soluble novolak resin is a novolak type phenol resin obtained by polycondensation between at least one of phenols and aldehydes such like formaldehyde.

As phenols to manufacture this alkali-soluble novolak resin, there may be illustrated, for example, cresols such as o-cresol, p-cresol, and m-cresol; xylenols such as 3,5-xylenol, 2,5-xylenol, 2,3-xylenol, and 3,4-xylenol; trimethylphenols such as 2,3,4-trimethylphenol, 2,3,5-trimethylphenol, 2,4,5-trimethylphenol, and 3,4,5-trimethylphenol; t-butylphenols such as 2-t-butylphenol, 3-t-butylphenol, and 4-t-butylphenol; methoxyphenols such as 2-methoxyphenol, 3-methoxyphenol, 4-methoxyphenol, 2,3-dimethoxyphenol, 2,5-dimethoxyphenol, and 3,5-dimethoxyphenol; ethylphenols such as 2-ethylphenol, 3-ethylphenol, 4-ethylphenol, 2,3-diethylphenol, 3,5-diethylphenol, 2,3,5-triethylphenol, and 3,4,5-triethylphenol; chlorophenols such as o-chlorophenol, m-chlorophenol, p-chlorophenol, and 2,3-dichlorophenol; resorcinols such as resorcinol, 2-methylresorcinol, 4-methylresorcinol, and 5-methylresorcinol; catechols such as 5-methylcatechol; pyrogallols such as 5-methylpyrogallol; bisphenols such as bisphenol-A, B, C, D, E, or F; methylolated cresols such as 2,6-dimethylolated-p-cresol; naphthols such as α-naphthol, β-naphthol, and the like. These are used singly or as a mixture of a plural number of kinds thereof.

As aldehydes, there may be illustrated salicylaldehyde, paraformaldehyde, acetaldehyde, benzaldehyde, hydroxybenzaldehyde, chloroacetaldehyde and so on besides formaldehyde. These are used singly or as a mixture of a plural number of kinds thereof.

The alkali-soluble novolak resin may be one wherein a low molecular weight component is removed by a fractionation or one wherein a low molecular weight component is not removed by a fractionation. As a method to remove a low molecular weight component by a fractionation, there are illustrated a liquid - liquid fractionation method whereby a novolak resin is fractionated in two kinds of solvents having a different solubility or with a method whereby a low molecular weight component is removed by a centrifugal separation, for example.

As a photosensitizer, a quinone diazide group containing photosensitizer can be raised as a representative one. Any publicly known photosensitizer which is so far being applied for a resist of a quinonediazide - novolak system can be applied. As those photosensitizers, a compound obtained by a reaction between quinone diazide sulfonic acidhalide such as naphthoquinone diazide sulfonic acid chloride or benzoquinone diazide sulfonic acid chloride and a low molecular weight compound or a high molecular weight compound containing a functional group which can be condensed with these acid halides is preferred. As functional groups which can be condensed with these acid halides, a hydroxyl group and an amino group can be exemplified and the hydroxyl group is particularly preferable. As a compound containing a hydroxyl group which can be condensed with acid halides, there may be illustrated hydroquinone, resorcin, hydroxybenzophenones such as 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone, 2,2',3,4,6'-pentahydroxybenzophenone and so on, hydroxyphenylalkanes such as bis(2,4-dihydroxyphenyl)methane, bis(2,3,4-trihydroxyphenyl)methane, bis(2,4-dihydroxyphenyl)propane and so on, hydroxytriphenylmethanes such as 4,4',3'',4''-tetrahydroxy-3,5,3',5'-tetramethyltriphenylmethane, 4,4',2'',3'',4''-pentahydroxy-3,5,3',5'-tetramethyltriphenyl-methane and so on. These compounds can be applied singly or as a mixture of two or more kinds. The photosensitizer containing a quinone diazide group is applied usually at 5 to 50 parts by weight, preferably 10 to 40 parts by weight relative to 100 parts by weight of the alkali-soluble resin.

As a solvent for the photosensitive resin composition of the present invention, there are illustrated ethylene glycol monoalkyl ethers such as ethylene glycol monomethyl ether, ethylene glycol monoethyl ether and so on; ethylene glycol monoalkyl ether acetates such as ethylene glycol monomethyl ether acetate, ethylene glycol monoethyl ether acetate and so on; propylene glycol monoalkyl ethers such as propylene glycol monomethyl ether, propylene glycol monoethyl ether and so on; propylene glycol monoalkyl ether acetates such as propylene glycol monomethyl ether acetate, propylene glycol monoethyl ether acetate and so on; lactic esters such as methyl lactate, ethyl lactate and so on; aromatic hydrocarbons such as toluene, xylene and so on; ketones such as methyl ethyl ketone, 2-heptanone, cyclohexanone and so on; amides such as N,N-dimethyl acetamide, N-methyl pyrrolidone and so on; lactones such as γ-butyro lactone, and the like. These solvents may be applied singly or in a mixture of two or more kinds thereof.

In the photosensitive resin composition of the present invention, there may be incorporated, if necessary, a dyestuff, adhesion aids and so on. Examples of a dyestuff include Methyl Violet, Crystal Violet, Malachite Green and so on, and examples of the adhesionaids include alkylimidazolines, butyric acid, alkyl acid, polyhydroxystyrene, polyvinyl methyl ether, t-butylnovolak, epoxysilane, epoxy polymers, silanes and so on.

The photosensitive resin composition of the present invention is prepared by dissolving the above described alkali-soluble resin, the photosensitizer, a particular sulfonyl group substituted nitrogen compound or a thiadiazole compound represented by the above described general formulae (1) to (8) and further other additives, if necessary into a solvent in a determined amount and by filtering the resultant solution, if necessary. The photosensitive resin composition prepared in such way is applied on a substrate for manufacturing a semiconductor integrated circuit device, a color filter, an FPD such as a liquid crystal display device. As a substrate whereon the photosensitive resin composition of the present invention is applied, there are exemplified substrates to be optionally chosen such as a glass substrate and a silicon substrate and a dimension thereof is also optionally chosen. These substrates may be ones whereon a coated film is formed such as chromium film, molybdenum film, silicon oxide film and so on. Application of the photosensitive resin composition onto a substrate may be any one so far known such as a spin coating method, a roll coatingmethod, a land coatingmethod, a flowing and spreading method, a doctor coating method, a dip coating method, a slit coating method and so on. After the photosensitive resin composition is applied on a substrate, it is prebaked to form a photoresist film. In the following step, the photoresist film is exposed to light and developed by a method so far publicly and widely known and a resist pattern without irregularity of line width and with a good shape can be formed.

Developers applied upon the above described development include any developers so far applied for a photosensitive resin composition. Preferable developers include an alkali developer which is an aqueous solution of alkaline compounds such as tetraalkyl ammonium hydroxide, corrin, alkali metal hydroxide, alkali metal metasilicic acid salt (hydrate), alkali metal phosphoric acid salt (hydrate), ammonia water, alkylamine, alkanol amine, hetero-cyclic amine and so on. A particularly preferable alkali developer is tetramethyl ammonium hydroxide aqueous solution. These alkali developers may contain, if necessary a water-soluble organic solvent such as methanol, ethanol and so on or a surfactant. After developing with an alkali developer, usually washing with water is carried out.

### Best mode for practicing the invention

The present invention will nowbe described more specifically by reference to Examples which, however, are not to be construed to limit the present invention in any way.

### Example-1

15 parts by weight of an esterified compound between 2,3,4,4'-tetrahydroxybenzophenone and 1,2-naphthoquinone diazide-5-sulfonyl chloride relative to 100 parts by weight of the novolak resin having a weight average molecular weight of 15,000 as determined by polystyrene standards, 300 ppm of Fluorad-472 manufactured by Sumitomo 3M Limited, which is a fluorine-containing surfactant, to the before describednovolak resin and further 1, 000 ppm of 1-mesitylensulfonyl-1,2,4-triazole as an adhesion improving agent were added to the novolak resin. Then the mixture was dissolved into propylene glycol monomethyl ether acetate and the resultant solution was stirred and filtered with a 0.2 **□**m-filter to prepare the photosensitive resin composition of the present invention. This composition was applied by spin coating on a 4-inch silicon wafer whereon Mo (molybdenum) film was formed, and then baked on a hotplate at 100°C for 90 seconds to obtain a resist film of 1. 5 **□**cm in thickness. This resist film was exposed to light by using a test pattern having line and space width of 1:1 and a various line width but even width for each pattern by a stepper FX604F manufactured by Nikon Co. , thereafter was developed with AZ300MIF Developer manufactured by Clariant (Japan) K.K. (2.38 weight % tetramethylammonium hydroxide aqueous solution) at 23°C for 80 seconds. After development, an optimal light exposure dose was 40 mJ/cm² by regarding a light exposure dose of 1:1 line and space with 5 **□**m width as an optimal light exposure dose. In the next step, evaluation for adhesion property was carried out under more severe condition, i.e. 1.4 times higher light exposure dose (56 mJ/cm²) to the optimal light exposure dose, by observing patters having 5 **□**m, 4 **□**m and 3 **□**m widths of line and space. ○ was put when no pattern peeling-off was observed, △ was put when pattern peeling-off was partially observed and X was put when all patterns were peeled-off and the result was obtained in Table-1.

### Example-2

The same manner was taken as Example-1 except applying 4,5-diphenyl-1,2,3-thiadiazole instead of 1-mesitylensulfonyl-1,2,4-triazole, and the result was obtained in Table-1.

### Comparative Example-1

The same manner was taken as Example-1 except applying no adhesion-improving agent and the result was obtained in Table-1.

### Comparative Example-2

The same manner was taken as Example-1 except applying diethyl(benzotriazole-1-yl)iminomalonate (manufactured by Lancaster Synthesis Co.) represented by the below-described formula (16) instead of 1-mesitylensulfonyl-1,2,4-triazole and the result was obtained in Table-1.

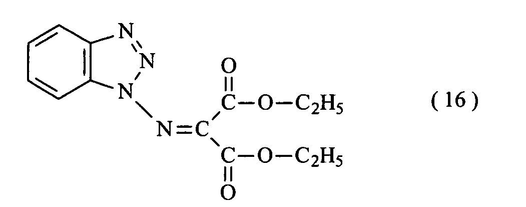

### Comparative Example-3

The same manner was taken as Example-1 except applying 1-hydroxyethyl-2-oxy-1,3-imidazoline C₈ to C₁₆ alkanoate (Monazoline C manufactured by MonaIndustry Co., Imidazoline 120H, manufactured by Rakeland Co.), which is typified by 1-hydroxyethyl-2-oxy-1,3-imidazolinelaurate represented by the below-described general formula (17), instead of 1-mesitylensulfonyl-1,2,4-triazole, and the result was obtained in Table-1. 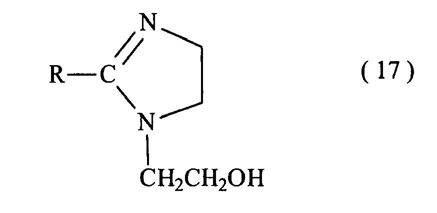 Wherein R represents -OCOR' and R' represents a linear or branched alkyl group.

**Table-1**

| | 5 **□**m | 4 **□**m | 3 **□**m |
|---|---|---|---|
| Example-1 | ○ | ○ | ○ |
| Example-2 | ○ | ○ | △ |
| Comparative Exampe-1 | × | × | × |
| Comparative Exampe-2 | ○ | △ | × |
| Comparative Example-3 | △ | × | × |

From the above results, by incorporating the adhesion improving agent of the present invention into a photosensitive resin composition, it proved that higher adhesion property-between the photosensitive resin composition and a substrate could be obtained compared with benzotriazoles or imidazoles so far known as adhesion-improving agents. And also it proved that the adhesion-improving agent of the present invention performed effectively even on a Mo film which especially has a problem of pattern peeling-off upon development.

In addition, the same examinations were carried out after the photosensitive resin compositions of Example-1 and 2 were stored at room temperature for 3 months and the similar results were obtained without causing deterioration of sensitivity and there was no problem in a storage stability.

### Effectiveness of the invention

As mentioned above in detail, the present invention applies a particular sulfonyl group substituted nitrogen compound or a thiadiazole compounds represented by the above described general formulae (1) to (8) as an adhesion-improving agent, by incorporating it into a photosensitive resin composition, the photosensitive resin composition without causing pattern peeling-off which is observed upon development or etching, no pattern collapse, having high adhesion property and being good in storage stability can be obtained. As a result, by applying the photosensitive resin composition of the present invention, excellent effectiveness to improve reduction of the yield which is caused by pattern peeling-off and so on can be obtained upon manufacturing an FPD and so on.

### Industrial Applicability

The adhesion-improving agent for a photosensitive resin composition of the present invention canprovide the photosensitive resin composition with an excellent adhesion property onto a substrate when being incorporated into the photosensitive resin composition. For this reason, the photosensitive resin composition wherein the adhesion-improving agent for a photosensitive resin composition of the present invention is incorporated can be suitably applied for a resist material and so on in manufacturing a semiconductor device and a flat panel display (FPD) such as a liquid crystal display device and so on.

## Claims

1. An adhesion-improving agent for a photosensitive resin composition comprising a sulfonyl group-substituted nitrogen compound represented by the general formulae (1) to (5) described below or a thiadiazole compound represented by the general formulae (6) to (8) described below; 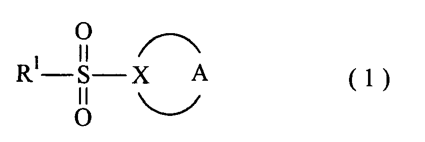 (Wherein R¹ represents a hydrogen atom, a hydroxyl group, an alkyl group of C₁ to C₅, a phenyl group which may contain substituted groups, -R²¹OH, -R²²OR²³, a halogen atom, an amino group, a cyano group, -R²⁴NH₂, R²⁵CN or an indole group which may contain substituted groups, R²¹, R²², R²⁴ and R²⁵ each independently represent an alkylene group or a phenylene group which may contain substituted groups, R²³ represents an alkyl group or a phenyl group which may contain substituted groups, X represents a carbon atom or a nitrogen atom, A represents a group of carbon atoms and/or nitrogen atoms which is required to form with X an aromatic hetero cyclic compound which may contain substituted groups.) 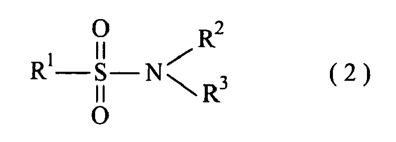 (Wherein R¹ represents the group or the atom defined by the above description, R² represents an alkyl group or a phenyl group which may contain substituted groups and R³ represents a nitroso group or an amino group.) 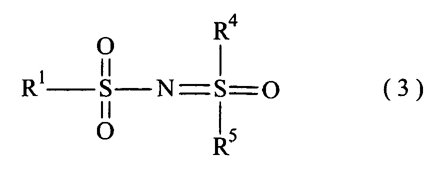 (Wherein R¹ represents the group or the atom defined by the above description, R⁴ and R⁵ each independently represent an alkyl group or a phenyl group which may be substituted.) 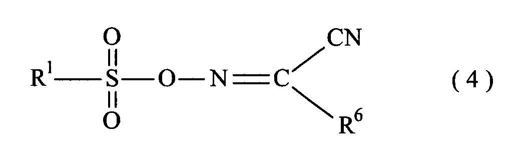 (Wherein R¹ represents the group or the atom defined by the above description, and R⁶ represents a naphthyl group or a phenyl group or a thiophene group which may be substituted.) 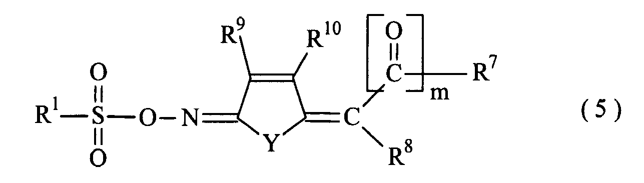 (Wherein R¹ represents the group or the atom defined by the above description, R⁷ and R⁸ each independently represent a phenyl group, a heteroaryl group, an alkoxycarbonyl group, a phenoxycarbonyl group or a cyano group which may be substituted, R⁹ and R¹⁰ each independently represent a hydrogen atom, a halogen atom, an alkyl group of C₁ to C₆, an alkoxy group of C₁ to C₆, a haloalkyl group of C₁ to C₄, a cyano group, a nitro group, an amino group, a substituted amino group, an alkoxycarbonyl group, a phenoxycarbonyl group, a phenyl group or an alkylthio group, R⁹ and R¹⁰ may form a condensed ring by bonding, Y represents an atom or atoms group which is required to form a heterocyclic five members or six members ring or carbon atoms which is required to form carbon six members ring, and m represents 0 or 1.) 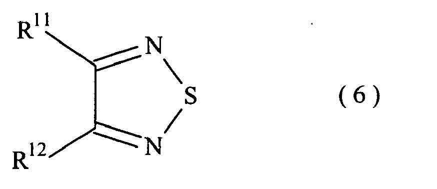 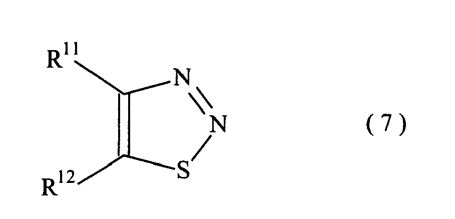 (Wherein R¹¹ and R¹² each independently represent a hydrogen atom, a halogen atom, a sulfide group, an amino group, a sulfoneamide group, an alkyl group, a perfluoroalkyl group, a phenyl group which may contain substituted groups or a group forming a condensed ring by bonding R¹¹ and R¹², which is substituted by a nitro group or an amino group.) 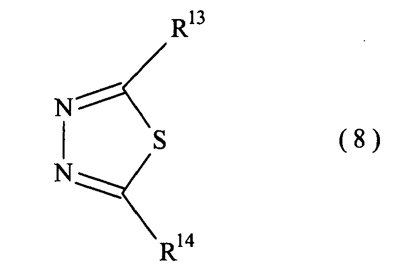 (Wherein R¹³ and R¹⁴ each independently represent an alkyl group of C₁ to C₅, a thiol group, an alkylmercapto group, a sulfonyl group, an amide group, an amino group, a sulfoneamide group, an acetylamino group or a fluorinated alkyl group.)

2. The photosensitive resin composition comprising an alkali-soluble resin and a photosensitizer according to claim 1, wherein the photosensitive resin composition comprises at least one species of a sulfonyl group-substituted nitrogen compound represented by the general formulae (1) to (5) or a thiadiazole compound represented by the general formulae (6) to (8).

3. The photosensitive resin composition according to claim 2, wherein the alkali-soluble resin is a novolak resin and the photosensitizer is a compound containing a quinone diazide group.
